Europäisches Patentamt

European Patent Office

Office européen des brevets

(19)

(11) Publication number: **0 031 680**
**B1**

## (12) EUROPEAN PATENT SPECIFICATION

(45) Date of publication of patent specification: **18.04.84**

(51) Int. Cl.³: **G 02 B 27/40, G 03 B 41/00**

(21) Application number: **80304570.7**

(22) Date of filing: **17.12.80**

(54) Focusing apparatus.

(30) Priority: **27.12.79 JP 169182/79**

(43) Date of publication of application:
**08.07.81 Bulletin 81/27**

(45) Publication of the grant of the patent:
**18.04.84 Bulletin 84/16**

(84) Designated Contracting States:
**DE FR GB**

(56) References cited:
**DE - B - 1 231 461**
**FR - A - 2 445 512**
**US - A - 3 819 265**
**US - A - 3 864 033**
**US - A - 4 230 940**

(73) Proprietor: **FUJITSU LIMITED**
**1015, Kamikodanaka Nakahara-ku**
**Kawasaki-shi Kanagawa 211 (JP)**

(72) Inventor: **Shida, Takao**
**22-6-102 Satsukigaoka Midori-ku**
**Yokohama-shi Kanagawa 227 (JP)**

(74) Representative: **Rackham, Stephen Neil et al,**
**GILL JENNINGS & EVERY 53-64 Chancery Lane**
**London WC2A 1HN (GB)**

Courier Press, Leamington Spa, England.

## Focusing apparatus

The present invention relates to a focusing apparatus, and more particularly relates to an optical focusing apparatus, preferably used in the manufacture of integrated semiconductor circuits.

Generally, in the manufacturing process of integrated semiconductor circuits (IC), an optical processing apparatus is very important, and is used to form very fine and precise circuits or logic patterns of an IC. For example, firstly such optical processing apparatus is necessary for exposing patterns through a reticle or shadow mask to be used as a so-called mask and, secondly such processing apparatus is also necessary to expose patterns on a photoresist film coated on a wafer.

Every time such optical processing apparatus is used, it is always necessary to focus it to obtain a sharp IC pattern image. This is because an optical processing apparatus provides a desired function with the aid of an optical lens. It should be noted that the present invention specifically refers to an apparatus which carries out the above mentioned focusing operation.

In the past, as will be explained in detail hereinafter, such focusing apparatus is set up so that a light beam is projected from a photo emitter non-normally onto an object on which the image is to be focused, and this light beam is reflected from the object and received by a photo detector. The correct location of the object with respect to the photo emitter and photo detector and hence the correct focus of the image on the object is determined by monitoring the output of the photo detector. When the intensity of the reflected light beam is at its maximum, the image is in focus on the object. However, a problem has arisen in that the intensity level varies not only with the location of the object, but also with variations in the condition of its surface. Accordingly, accurate focusing is only obtained with some surfaces such as when a wafer to be focused on has on its surface particular uniform patterns extending parallel so that a furrowed or ridged surface is obtained as a result of usual etching process during a previous IC manufacturing step.

According to this invention this problem is overcome by providing a plurality of opposed photoemitters and photodetectors around the object, the sum of the intensity levels detected by all of the photodetectors or the average intensity level detected by all of the photodetectors being applied to the means for adjusting the relative position of the lens and the object.

This enables the intensity of a plurality of light beams having different orientations with respect to the object to be monitored simultaneously and at least one will always have the correct orientations with respect to the object to be able to exercise effective control over the focusing operation.

A particular example of two examples of apparatus in accordance with the present invention will now be described and contrasted with the prior art with reference to the accompanying drawings in which:—

Figure 1 is a perspective view of a part of an IC manufacturing apparatus including a prior focusing apparatus;

Figure 2 is a diagrammatic front elevation of the prior focusing apparatus;

Figures 3A and 3B are plans of the prior focusing apparatus;

Figure 4A is a plan of the first example in accordance with this invention; and,

Figure 4B is a plan of a second example in accordance with this invention.

An IC manufacturing apparatus 10 has previously included a focusing apparatus comprising a single photoemitter 11e, such as a light emitting diode producing an infra-red light, and a single photodetector 11d, such as a photo diode which is sensitive only to infra-red light. The photoemitter 11e produces a light beam to be illuminated onto an object 16 to be focused on, via a mirror 12e and a light expanding lens 13e. The object 16 is specifically a part of a wafer 14 for fabricating the ICs. In order to form the desired circuit and logic patterns on the object 16 a photoresist film (not shown), which is sensitive only to ultraviolet light is coated on the object 16. The desired IC image is created by means of a reticle R and an optical system OS being provided with a lens LS and an optical tube OT. A light source (not shown) provides a strong light L, such as an ultraviolet ray light toward said photoresist via the reticle R and the lens LS, so that a desired IC image, defined by the reticle R, can be exposed on the photoresist of the object 16. In order to obtain a fine and precise IC image on the object 16, the focal point of the lens LS must correctly be determined just on the object 16. In order to achieve this, a means 15 is employed in the system 10, for arresting the correct focal point just thereon. The expanded light beam from the lens 13e is reflected by the object, and the reflected light beam is applied to a photodetector 11d, via a converging lens 13d and a mirror 12d. The output of the photodetector 11d is applied to the means 15 so as to drive a computer controller servo-motor SM. The servo-motor SM can adjust the separation between the lens LS and the object 16.

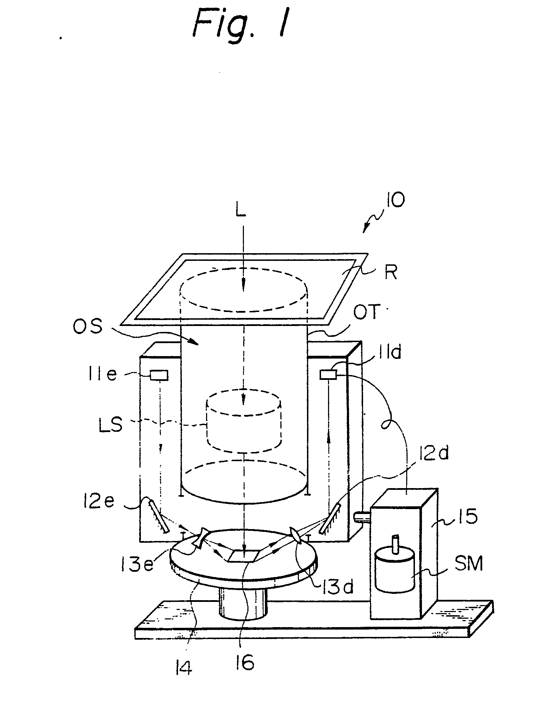

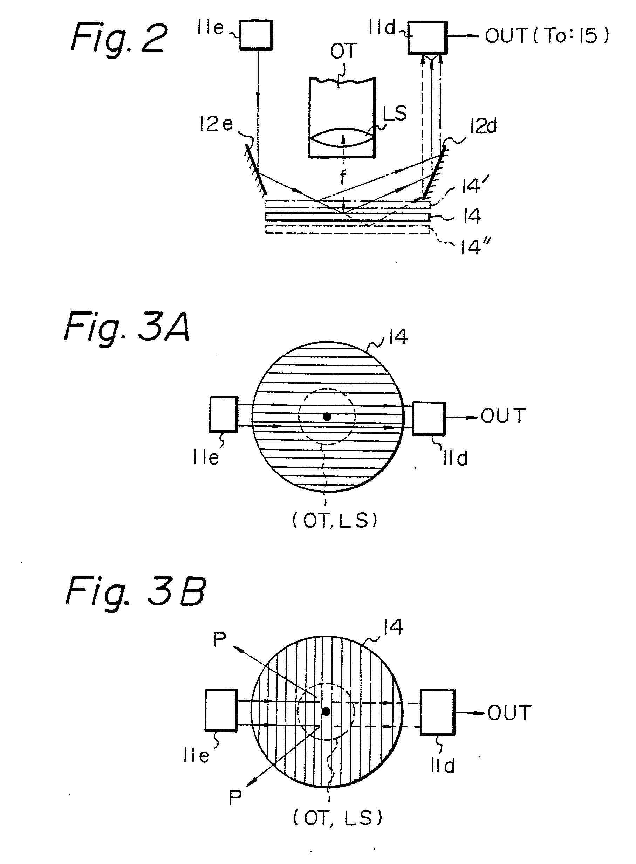

The operational principle of the focusing apparatus can be understood with reference to Figure 2, which is a schematic partial front view of the system 10 shown in Figure 1. In Figure 2, members which are represented by the same reference numerals and symbols as those of Figure 1, are identical to each other. First, the image on the wafer 14, illustrated by a solid line, is initially located at a position corresponding to a shown distance f which is the image distance of the lens LS. Such correct focusing point can be determined by manual operation through some trial exposures until a very fine and precise IC image can be obtained. At this time, the light beam, projected from the light emitter 11e, travels to the light detector 11d along a path indicated by solid line arrows. Therefore, the detector 11d produces an output having a maximum intensity level.

The above mentioned initial adjustment for arresting the correct focusing point, is achieved with respect to one of the chips to be formed on the wafer 14 (Figure 1). Accordingly, it is not guaranteed that the remaining chips can also arrest the correct focal point, every time each chip is transferred and located right beneath the lens LS. This is because, usually, the wafer 14 (Figure 1) has, on its surface, very small undulations on the order of about 1 $\mu$m in depth after some etching processes. Accordingly, some chips may be located slightly above the level of the reference level (14), such as shown by the chain-dotted line 14'. Alternately, some objects may be located slightly under the level of the reference level (14), as is shown by the broken line 14". In such cases, the photodetector 11d does not produce the output having a maximum intensity level, as will be understood from paths indicated by broken line arrows and chain-dotted line arrows, thereby the respective reflected light beams are not illuminated onto the center of the photodetector 11d. Consequently, the detector 11d produces an output having a relatively low intensity level. Then the means 15 of Figure 1 adjusts the relative position of the lens and the object 16 until an output having the maximum intensity level is obtained so as to move the object 16 to the level where the reference level (14) is located.

The above mentioned operational principle is effectively realized, if each chip has, on its surface, good condition for putting the operational principle into practical use. However, it should be noted that each chip has not always, on its surface, such good condition. If the system 10 (Figure 1) deals with an object 16 having a particular pattern extending parallelly in the same direction, the above mentioned good condition cannot be expected. An object 16, having such particular pattern, is often introduced in the system 10. For example, such pattern is formed on a wafer to be fabricated as a so-called masterslice semiconductor device. As is known in the masterslice semiconductor device, a great number of basic logics and conductors are preformed uniformly on the wafer. Especially, such great number of basic conductors prevent one from putting the above mentioned operational principle into practical use. In other words, it is impossible to perform focusing operation with a high degree of accuracy, when such a masterslice semiconductor device is processed in the system 10 (Figure 1). The reason for this will be clarified with reference to Figures 3A and 3B. Figures 3A and 3B are plan views of objects having particular patterns thereon. In these figures, the members 11e, 11d, 14, OT and LS have already been explained. The black dot indicates the centre of the object 16 (Figure 1) when the particular pattern is formed by a number of features extending parallel, a ridged or furrowed surface structure is formed. The light beams from the photoemitter 11e are reflected to the photodetector 11d without trouble when they are aligned with the ridges. But when this particular pattern is oriented so that they are not aligned with the light beams as shown in Figure 3B, the light beams projected from the photoemitter 11e are scattered and do not travel towards the photodetector 11d. The straight lines of the particular pattern are formed as ridges, the height of which is typically of the order of several $\mu$ms, and the light beams are reflected as scattered as light beams P, by the sides of the ridges and this reduces the intensity level of the output (OUT). In this case, although the correct focal point is just on the object, the means 15 (Figure 1) fail to detect this and continue moving the lens. As a result, a high accurate and precise focusing function is lost.

If an operator orients the object to align the straight lines of the particular pattern with the paths of the light beams, as shown in Figure 3A, every time the wafer, having such a particular pattern, is introduced into the system, it is possible to always conduct an accurate and precise focusing operation. However, such operation by the operator, as mentioned above, is not practical from an economical point of view in a mass-production system.

The focusing apparatus according to the present invention can allow the operator to carry out the focusing operation without taking the alignment, between the above mentioned ridges and the path of the light beam, into account. According to the focusing apparatus of the present invention, a plurality of optical sets are distributed around the object, wherein each of the optical sets is comprised of both one photoemitter and the corresponding photodetector and both are located symmetrically with respect to the object. Accordingly, the means 15 of Figure 1 can receive outputs from a plurality of photodetectors simultaneously. Thus, the means 15 can supervise the average intensity level of a plurality of reflected light beams, thereby undesired light beams P of Figure 3B can be disregarded.

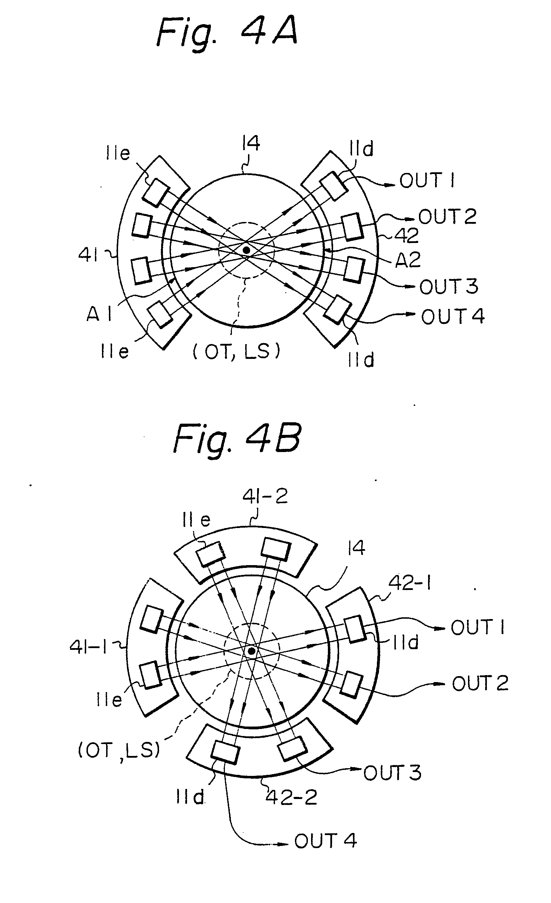

A first embodiment of the focusing apparatus according to the present invention is depicted as a plan view, in Figure 4A. A second embodiment thereof is in Figure 4B. In both figures, the members 11e, 11d, 14, OT and LS have already been explained. It should be understood that the mirrors (12e, 12d) and lenses (13e, 13d), shown in Figure 1, are not illustrated in Figures 4A and 4B, because these members are not essential members of the present invention. In Figure 4A, a photoemitter group 41 is arranged along one half arc A1 of a circular area. The center of the object coincides with the center of said circular area. At the same time, a photodetector group 42 is arranged along opposite half arc A2 of said circular area. The photoemitter group 41 includes therein a plurality of photoemitters 11e. The photodetector group 42 includes therein a plurality of photodetectors 11d. The photoemitters are distributed one by one along the arc A1. The photodetectors are also distributed one by one along the arc A2. Each of the photoemitters 11e and the corresponding photodetectors 11d are arranged symmetrically with respect to the center of the object 16 (Figure 1). The photodetectors 11d, when there exists four photodetectors, produces respective outputs OUT1 through OUT4 indicating respective intensity levels of the reflected light beam.

In Figure 4B, the photoemitter group 41 of Figure 4A is divided into a plurality of small photoemitter groups 41-1 and 41-2. Similarly, the photodetector group 42 of Figure 4A is divided into a plurality of small photodetector groups 42-1 and 42-2. The number, by which each of the groups 41 and 42 is divided, is not limited to two, but can be more than two.

As mentioned above, the focusing apparatus of the present invention can always achieve the focusing operation with a high degree of accuracy, regardless of the surface condition, that is the circuit and logic pattern, of the water to be focused on.

## Claims

1. A focusing apparatus for adjusting the relative position of an object (16) and a lens (LS), comprising a photoemitter (11e) for projecting a light beam non-normally onto the object (16), a photodetector for receiving the light reflected from said object (16), and means (15, SM) for adjusting the correct relative position of the lens (LS) and the object (16) in response to the intensity level of the reflected light beam detected by the photodetector, characterised in that a plurality of opposed photoemitters (11e) and photodetectors are provided around the object (16) and that the sum of the intensity levels detected by all of the photodetectors (11d) or the average intensity level detected by all the photodetectors is applied to the means (15, SM) for adjusting the relative position of the lens (LS) and the object (16).

2. An apparatus according to claim 1, further characterised in that the photoemitters (11e) are arranged in a semicircle at one side of the object (16) and in that the photodetectors (11d) are arranged in a semicircle at the other side of the object (16) with the object at the centre of the semicircles.

3. An apparatus according to claim 1 or 2, further characterised in that the photoemitters (11e) and the photodetectors (11d) are arranged in groups.

## Revendications

1. Appareil de mise au point permettant d'ajuster la position relative d'un objet (16) et d'un objectif (LS), comprenant un photoémetteur (11e) qui projette un faisceau lumineux de manière non perpendiculaire sur l'objet (16), un photodétecteur qui reçoit la lumière réfléchie par l'objet (16), et un moyen (15, SM) qui ajuste la position relative correcte de l'objectif (LS) et de l'objet (16) en réponse au niveau d'intensité du faisceau lumineux réfléchi détecté par le photodétecteur, caractérisé en ce que plusieurs photoémetteurs (11e) opposés sont disposés autour de l'objet (16) et en ce que la somme des niveaux d'intensité détectés par tous les photodétecteurs (11d) ou le niveau d'intensité moyen détecté par tous les photodétecteurs est appliqué au moyens (15, SM) afin d'ajuster la position relative de l'objectif (LS) et de l'objet (16).

2. Appareil selon la revendication 1, caractérisé en outre en ce que les photoémetteurs (11e) sont disposés dans un demicercle d'un côté de l'objet (16) et en ce que les photodétecteurs (11d) sont disposés dans un demicercle sur l'autre côté de l'objet (16), l'objet se trouvant au centre des demi-cercles.

3. Appareil selon la revendication 1 ou 2, caractérisé en outre en ce que les photoémetteurs (11e) et les photodétecteurs (11d) sont disposés en groupes.

## Patentansprüche

1. Fokussiergerät zur Einstellung der relativen Position eines Objektes (16) und einer Linse (LS) mit einem Photoemitter (11e) zur Projektion eines Lichtstrahls rechtwinklig auf das Objekt (16), einem Photodetektor zum Emfang des Lichtes, welches von dem genannten Objekt (16) reflektiert wird, und mit Einrichtungen (15, SM) zur Einstellung der korrekten Relativposition der Linse (LS) und des Objektes (16) in Abhängigkeit von dem Intensitätspegel des reflektierten Lichtstrahls, welcher von dem Photodetektor erfaßt wird, dadurch gekennzeichnet, daß eine Anzahl von einander gegenüber angeordneten Photoemittern (11e) und Photodetektoren um das Objekt (16) angeordnet sind und die Summe der Intensitätspegel, welche von allen Photodetektoren (11d) erfaßt werden oder der mittlere Intensitätspegel, welcher von allen Photodetektoren erfaßt wird, der Einrichtung (15, SM) zur Einstellung der relativen Position von Linse (LS) und Objekt (16) verwendet wird.

2. Vorrichtung nach Anspruch 1, dadurch gekennzeichnet, daß die Photoemitter (11e) in einem Halbkreis auf einer Seite des Objekts (16) angeordnet sind und daß die Photodetektoren (11d) in einem Halbkreis auf der anderen Seite des Objekts (16) angeordnet sind, wobei das Objekt sich im Mittelpunkt der Halbkreise befindet.

3. Vorrichtung nach Anspruch 1 oder 2, dadurch gekennzeichnet, daß die Photoemitter (11e) und die Photodetektoren (11d) in Gruppen angeordnet sind.

# Fig. 1

Fig. 2

Fig. 3A

Fig. 3B

## Fig. 4A

## Fig. 4B